# EUROPÄISCHE PATENTSCHRIFT

(11) **EP 0 435 021 B1**
(45) Veröffentlichungstag und Bekanntmachung des Hinweises auf die Patenterteilung: **12.03.1997**
(21) Anmeldenummer: 90123130.8
(22) Anmeldetag: 03.12.1990
(51) Int. Cl.: H01L 21/332, H01L 29/08

(54) **Verfahren zum Herstellen von anodenseitigen Kurzschlüssen in Thyristoren**
Method for manufacturing anode side short circuits in thyristors
Procédé de fabrication des courts-circuits dans le côté anode des thyristors

(30) Priorität: 19.12.1989 DE 3941932
(43) Veröffentlichungstag der Anmeldung: 03.07.1991
(73) Patentinhaber: EUPEC Europäische Gesellschaft für Leistungshalbleiter mbH & Co. KG, D-59581 Warstein (DE)
(72) Erfinder: Schuh, Gottfried, W-8900 Augsburg (DE); Schulze, Hans Joachim, Dr., W-8012 Ottobrunn (DE)
(74) Vertreter: Fuchs, Franz-Josef, Dr.-Ing.

(56) Entgegenhaltungen:
- EP-A- 0 206 136
- EP-A- 0 313 000
- DE-A- 3 742 638
- 19TH ANNUAL IEEE POWER ELECTRONICS SPECIALISTS CONF., TECHNICAL DIGEST (PESC
- '88 RECORD) Bd. 2, 11. April 1988, KYOTO, JAPAN Seiten 903 - 907; T. OGURA ET AL.: 'Low switching loss, high power gate turn-off thyristors (GTOS) with N- buffer and new anode short structure'
- PATENT ABSTRACTS OF JAPAN vol. 13, no. 503 (E-844)(3851) 13. November 1989 & JP-A- 1 201 957

## Beschreibung

Die Erfindung bezieht sich auf ein Verfahren zum Herstellen von anodenseitigen Kurzschlüssen in Thyristoren, die eine AnodenBasiszone vom ersten Leitungstyp und eine anodenseitige Emitterzone vom zweiten Leitungstyp haben.

Anodenseitige Kurzschlüsse sind bei GTO-Thyristoren erforderlich, da hier keine katodenseitigen Kurzschlüsse möglich sind. Sie sind vorteilhaft auch bei asymmetrisch, d. h. nur in Kipprichtung sperrenden Thyristoren zusätzlich zu katodenseitigen Kurzschlüssen anwendbar, da sich damit die anodenseitige Speicherladung im Halbleiterkörper und damit die Freiwerdezeit herabsetzen läßt.

Ziel der Erfindung ist es, ein besonders einfaches Verfahren für die Herstellung solcher anodenseitigen Kurzschlüsse anzugeben. Insbesondere soll hierbei lediglich eine einzige zusätzliche Maske erforderlich sein.

Diese Aufgabe wird durch die Schritte des Anspruchs 1 oder des Anspruchs 3 gelöst.

Weiterbildungen der Erfindung sind Gegenstand der Unteransprüche.

Die Erfindung wird anhand der FIG 1 bis 9 näher erläutert. Dabei zeigen
- FIG 1 bis 6: ein erstes Ausführungsbeispiel anhand charakteristischer Verfahrensschritte am Halbleiterkörper eines Thyristors und
- FIG 7 bis 9: ein zweites Ausführungsbeispiel ebenfalls anhand charakteristischer Verfahrensschritte bei einem Thyristor.

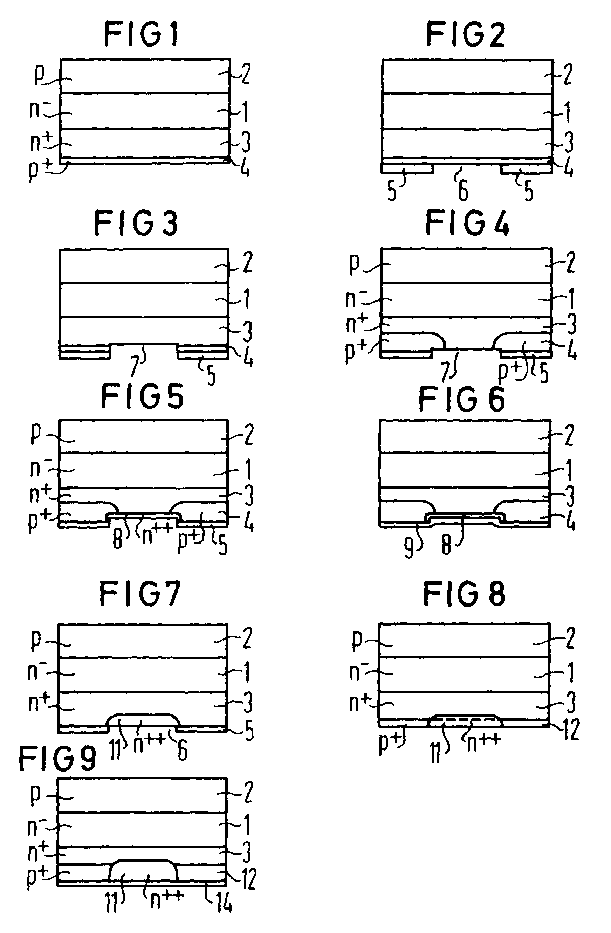

Der Halbleiterkörper nach FIG 1 hat eine schwach n-dotierte Anodenbasiszone 1. An sie schließt sich katodenseitig eine p-dotierte Katodenbasiszone 2 an. Diese hat eine höhere Nettodotierungskonzentration als die Zone 1. Anodenseitig grenzt an die Zone 1 eine stark n-dotierte Zone 3 an, die als sogenannte Stopschicht wirkt. Sie verhindert einen anodenseitigen Punchthrough bei Belastung in Kipprichtung. Die erwähnten Zonen werden auf herkömmliche Art und Weise erzeugt. Als erster Verfahrensschritt gemäß Erfindung wird anodenseitig eine stark p-dotierte Zone 4 z. B. durch Ionenimplantation mit Bor oder Aluminium erzeugt. Als nächster Verfahrensschritt (FIG 2) wird auf der anodenseitigen Oberfläche des Halbleiterkörpers eine Maskierschicht 5 aufgebracht, welche z. B. durch Oxidation der anodenseitigen Oberfläche des Halbleiterkörpers oder durch Aufbringen von CVD-Oxid erzeugt werden kann.

Dann wird in die Schicht 5 eine Öffnung 6 geätzt. Anschließend wird (FIG 3) in die anodenseitige Oberfläche des Halbleiterkörpers eine Vertiefung 7 geätzt, wobei die Maskierschicht 5 als Ätzmaske dient. Die Ätzung wird so lange fortgesetzt, bis die Zone 4 durchgeätzt ist und die Oberfläche der Stopschicht 3 freiliegt. Der Ätzvorgang kann auch soweit vorangetrieben werden, daß in der Oberfläche der Stopschicht 3 eine Vertiefung entsteht.

Wird eine größere Tiefe der Zone 4 gewünscht, so kann sie nachfolgend durch Tempern in die Stopschicht 3 eingetrieben werden, wie in FIG 4 gezeigt. Als nächster Schritt (FIG 5) wird in der Vertiefung 7 z. B. durch Ionenimplantation mit anschließendem Temperschritt oder eine Phosphor-Diffusion eine n-dotierte Zone 8 mit sehr hoher Dotierung erzeugt. Hierbei dient die Maskierschicht 5 wiederum als Maske. Als letzter wesentlicher Schritt (FIG 6) wird die Maskierschicht 5 entfernt und anodenseitig eine Kontaktschicht 9 aufgebracht. Diese dient als Anodenelektrode und besteht beispielsweise aus Aluminium. Sie bildet auch den Kurzschluß zwischen der als Anodenemitterzone wirkenden Zone 12 und der zur Anodenbasiszone 1 gehörenden Stopschicht 3.

Alternativ kann nach Ablösen der Maskierschicht auch eine anodenseitige Legierung (z.B. Al-Si) zur Kontaktierung und allgemein zum Verbinden des Thyristors mit einer Trägerplatte (z. B. Mo) durchgeführt werden. Im Fall der Legierung muß die Konzentration der Zone 8 deutlich höher gewählt werden als die z. B. durch eine Al-Legierung erzeugte p-Dotierung.

Die sonstigen, für einen asymmetrischen Thyristor oder GTO-Thyristor erforderlichen Verfahrensschritte wie Herstellen der Katodenemitterzonen, Randbehandlung usw. werden hier nicht beschrieben, sie sind Stand der Technik.

Statt der beschriebenen Schichtenfolge pn⁻n⁺p⁺ von der Katodenseite zur Anodenseite läßt sich die Erfindung auch bei einer inversen Dotierung verwenden.

Gemäß einer Alternative der Erfindung wird der Halbleiterkörper anodenseitig wieder mit einer Maskierschicht 5 versehen, in die eine Öffnung 6 geätzt wird. Dann wird eine stark n-dotierte Zone 11 durch die Öffnung 6 in der Oberfläche der Stopschicht 3 erzeugt und die Maskierschicht 5 wieder entfernt (FIG 7). Beim nächsten Verfahrensschritt (FIG 8) wird eine p-dotierte Zoen 12 in der anodenseitigen Oberfläche der Stopschicht 3 erzeugt. Die Zone 12 hat eine Nettodotierung, die geringer ist als die der Zone 11, jedoch höher als die der Zone 3. Anschließend können die Zonen 11 und 12 in den Halbleiterkörper eingetrieben werden (FIG 9). Die Anodenseite des Halbleiterkörpers wird dann mit einer Kontaktschicht 14 versehen, die den Anodenkontakt bildet. Sie bildet auch den Kurzschluß zwischen der als Anodenemitter wirkenden Zone 12 und der zur Anodenbasiszone 1 gehörenden Stopschicht 3.

Alternativ kann auch hier wieder bei ausreichender Dotierung der Zone 11 nach Erzeugung der Zone 11 eine anodenseitige Legierung (z. B. Al-Si) zur Kontaktierung und zum Verbinden des Thyristors mit einer Trägerplatte durchgeführt werden. Als weitere Alternative bietet es sich an, bei einer Al-Si-Legierung auf die Schritte zur Herstellung der Zone 12 zu verzichten, da eine Legierung mit Al selber eine p-dotierte Schicht erzeugt.

Auch bei diesem Ausführungsbeispiel ist eine Schichtfolge mit inverser Dotierung möglich.

## Patentansprüche

1. Verfahren zum Herstellen von anodenseitigen Kurzschlüssen in Thyristoren, die eine Anodenbasiszone (1) vom ersten Leitungstyp und eine anodenseitige Emitterzone (4) vom zweiten Leitungstyp haben, mit den Schritten:
a) Auf der Anodenbasiszone (1) wird eine Stopschicht (3) erzeugt, die den gleichen Leitungstyp wie die Anodenbasiszone hat, aber höhere Dotierung als diese;
b) auf der Stopschicht (3) wird ganzflächig die Emitterzone (4) vom zweiten Leitungstyp erzeugt ;
c) die Emitterzone (4) vom zweiten Leitungstyp wird ganzflächig mit einer Maskierschicht (5) bedeckt ;
d) die Maskierschicht (5) wird fotolithografisch strukturiert;
e) in den Halbleiterkörper werden entsprechend der Struktur der Maskierschicht Vertiefungen (7) geätzt, die bis in die Stopschicht (3) reichen;
f) in den Vertiefungen (7) werden Zonen (8) des ersten Leitungstyps erzeugt, die eine höhere Dotierungskonzentration als die Stopschicht (3) haben;
g) die Maskierschicht (5) wird entfernt;
h) die anodenseitige Oberfläche des Halbleiterkörpers wird mit einer Kontaktschicht (9) bedeckt.

2. Verfahren nach Anspruch 1,
**dadurch gekennzeichnet,** daß die Emitterzone (4) des zweiten Leitungstyps vor der Erzeugung der Zonen (8) des ersten Leitungstyps in den Halbleiterkörper eingetrieben wird.

3. Verfahren zum Herstellen von anodenseitigen Kurzschlüssen, die eine Anodenbasiszone (1) vom ersten Leitungstyp und eine anodenseitige Emitterzone (12) vom zweiten Leitungstyp haben, mit den Schritten:
a) Auf der Anodenbasiszone (1) wird eine Stopschicht (3) erzeugt, die den gleichen Leitungstyp wie die Anodenbasiszone (1) hat, aber höhere Dotierung als diese;
b) die Stopschicht (3) wird ganzflächig mit einer Maskierschicht (5) bedeckt;
c) die Maskierschicht (5) wird fotolithografisch strukturiert;
d) in der Stopschicht (3) werden entsprechend der Struktur Zonen (11) des ersten Leitungstyps mit höherer Dotierung als die Stopschicht (3) erzeugt;
e) die strukturierte Maskierschicht (5) wird entfernt;
f) in der Stopschicht (3) wird die anodenseitige Emitterzone (12) erzeugt, deren Dotierung geringer ist als die der Zonen (11) des ersten Leitungstyps;
g) die anodenseitige Oberfläche des Halbleiterkörpers wird mit einer Kontaktschicht (14) bedeckt.

4. Verfahren nach Anspruch 3,
**dadurch gekennzeichnet**, daß die Emitterzone (12) des zweiten Leitungstyps und die Zonen (11) des ersten Leitungstyps vor dem Aufbringen der Kontaktschicht (14) in den Halbleiterkörper eingetrieben werden.

5. Verfahren nach Anspruch 1 oder 3,
**dadurch gekennzeichnet,** daß die Kontaktschicht (14) durch eine Legierung erzeugt wird.

6. Verfahren nach Anspruch 3,
**dadurch gekennzeichnet,** daß die Emitterzone (12) und die Kontaktschicht (14) durch das Aufbringen einer dotierstoffhaltigen Kontaktschicht erzeugt werden.

## Claims

1. Method for manufacturing anode-side short circuits in thyristors, which have an anode base zone (1) of the first conduction type and an anode-side emitter zone (4) of the second conduction type, having the steps:
a) a stop layer (3) is produced on the anode base zone (1), which stop layer has the same conduction type as the anode base zone but has a higher doping than the latter;
b) the emitter zone (4) of the second conduction type is produced over the whole area of the stop layer (3);
c) the emitter zone (4) of the second conduction type is covered over the whole area with a masking layer (5);
d) the masking layer (5) is photolithographically structured;
e) depressions (7) extending into the stop layer (3) are etched into the semiconductor body in accordance with the structure of the masking layer;
f) zones (8) of the first conduction type are produced in the depressions (7), which zones have a higher doping concentration than the stop layer (3);
g) the masking layer (5) is removed;
h) the anode-side surface of the semiconductor body is covered with a contact layer (9).

2. Method according to Claim 1, characterized in that the emitter zone (4) of the second conduction type is driven into the semiconductor body before the production of the zones (8) of the first conduction type.

3. Method for manufacturing anode-side short circuits in thyristors, which have an anode base zone (1) of the first conduction type and an anode-side emitter zone (12) of the second conduction type, having the steps:
a) a stop layer (3) is produced on the anode base zone (1), which stop layer has the same conduction type as the anode base zone (1) but has a higher doping than the latter;
b) the stop layer (3) is covered over the whole area with a masking layer (5);
c) the masking layer (5) is photolithographically structured;
d) zones (11) of the first conduction type with a higher doping than the stop layer (3) are produced in the stop layer (3) in accordance with the structure;
e) the structured masking layer (5) is removed;
f) the anode-side emitter zone (12), whose doping is lower than that of the zones (11) of the first conduction type, is produced in the stop layer (3);
g) the anode-side surface of the semiconductor body is covered with a contact layer (14).

4. Method according to Claim 3, characterized in that the emitter zone (12) of the second conduction type and the zones (11) of the first conduction type are driven into the semiconductor body before the application of the contact layer (14).

5. Method according to Claim 1 or 3, characterized in that the contact layer (14) is produced by an alloy.

6. Method according to Claim 3, characterized in that the emitter zone (12) and the contact layer (14) are produced by the application of a dopant-containing contact layer.

## Revendications

1. Procédé de production de courts-circuits côté anode dans des thyristors qui ont une zone (1) anode-base du premier type de conductivité et une zone (4) d'émetteur côté anode du deuxième type de conductivité, comportant les étapes:
a) on produit sur la zone (1) anode-base une couche (3) d'arrêt, qui a le même type de conductivité que la zone anode-base, mais qui est plus fortement dopée que cette dernière;
b) on produit sur toute la surface de la couche (3) d'arrêt la zone (4) d'émetteur du deuxième type de conductivité;
c) on recouvre toute la surface de la zone (4) d'émetteur du deuxième type de conductivité d'une couche (5) de masquage;
d) on structure la couche (5) de masquage par photogravure;
e) on ménage par attaque chimique dans l'élément en semi-conducteur, suivant la structure de la couche de masquage, des cavités (7) qui vont jusque dans la couche (3) d'arrêt;
f) on produit dans les cavités (7) des zones (8) du premier type de conductivité qui ont une concentration de dopage plus grande que la couche (3) d'arrêt;
g) on enlève la couche (5) de masquage;
h) on recouvre la surface côté anode de l'élément en semi-conducteur d'une couche (9) de contact.

2. Procédé suivant la revendication 1, caractérisé en ce que, avant de produire les zones (8) du premier type de conductivité, on enfonce la zone (4) d'émetteur du deuxième type de conductivité dans l'élément en semi-conducteur.

3. Procédé de production de courts-circuits côté anode qui ont une zone (1) anode-base du premier type de conductivité et une zone (12) d'émetteur côté anode du deuxième type de conductivité, comportant les étapes:
a) on produit sur la zone (1) anode-base une couche (3) d'arrêt, qui a le même type de conductivité que la zone (1) anode-base, mais qui est plus fortement dopée que cette dernière;
b) on recouvre toute la surface de la couche (3) d'arrêt d'une couche (5) de masquage;
c) on structure la couche (5) de masquage par photogravure;
d) on produit dans la couche (3) d'arrêt, suivant la structure, des zones (11) du premier type de conductivité plus fortement dopées que la couche (3) d'arrêt;
e) on enlève la couche (5) de masquage;
f) on produit dans la couche (3) d'arrêt la zone (12) d'émetteur côté anode dont le dopage est inférieur à celui des zones (11) du premier type de conductivité
g) on recouvre la surface côté anode de l'élément en semi-conducteur d'une couche (14) de contact.

4. Procédé suivant la revendication 3, caractérisé en ce que, avant de déposer la couche (14) de contact, on enfonce la zone (12) d'émetteur du deuxième type de conductivité et les zones (11) du premier type de conductivité dans l'élément en semi-conducteur.

5. Procédé suivant la revendication 1 ou 3, caractérisé en ce qu'on produit la couche (14) de contact par un alliage.

6. Procédé suivant la revendication 3, caractérisé en ce qu'on produit la zone (12) d'émetteur et la couche (14) de contact, en déposant une couche de contact à teneur en substance dopante.
